(19) **Europäisches Patentamt / European Patent Office / Office européen des brevets**

(11) **EP 2 145 172 B1**

(12) # EUROPÄISCHE PATENTSCHRIFT

(45) Veröffentlichungstag und Bekanntmachung des Hinweises auf die Patenterteilung:
**01.12.2010 Patentblatt 2010/48**

(51) Int Cl.:
***G01N 15/04*** *(2006.01)*  ***G01R 33/12*** *(2006.01)*

(21) Anmeldenummer: **08749921.6**

(22) Anmeldetag: **30.04.2008**

(86) Internationale Anmeldenummer:
**PCT/EP2008/055335**

(87) Internationale Veröffentlichungsnummer:
**WO 2008/132227 (06.11.2008 Gazette 2008/45)**

(54) **BESTIMMUNG VON PARTIKELEIGENSCHAFTEN DURCH ÜBERLAGERTE FELDER**

DETERMINING PARTICLE PROPERTIES BY MEANS OF SUPERIMPOSED FIELDS

DETERMINATION DES PROPRIETES DES PARTICULES PAR RECOUVREMENT DE CHAMPS

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **30.04.2007 DE 102007020646**

(43) Veröffentlichungstag der Anmeldung:
**20.01.2010 Patentblatt 2010/03**

(73) Patentinhaber: **L.U.M. GmbH**
**12489 Berlin (DE)**

(72) Erfinder:
• **LERCHE, Dietmar**
**12524 Berlin (DE)**
• **MERTENS, Uwe**
**12247 Berlin (DE)**

(74) Vertreter: **Wehlan, Helmut**
**Patentanwälte Wehlan & Wehlan**
**Möllendorffstrasse 49**
**10367 Berlin (DE)**

(56) Entgegenhaltungen:
DE-A1- 10 208 707    DE-A1- 19 542 225
DE-B- 1 013 899    US-A- 5 095 451
US-A1- 2003 113 926    US-A1- 2004 211 669

• ZIMMELS Y: "Principles of electrocentrifugal separation" 19881002; 19881002 - 19881007, 2. Oktober 1988 (1988-10-02), Seiten 1765-1770, XP010519319

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Stand der Technik

Die Charakterisierung von Teilchen im Bereich der Nano- oder Biotechnologie erlangt mit der stetig komplexeren Teilchenstruktur eine immer größere Bedeutung. Dies betrifft einmal die Produktanforderungen (z.B. Magnetbeads) und zum anderen die Realisierung und Optimierung von verfahrenstechnischen Trennverfahren (z.B. Magnetseparation, Elektrokoagulation). Um diesen neuen Anforderungen gerecht zu werden, müssen neben der Größe und der Form der Teilchen zunehmend elektrische und magnetische Teilcheneigenschaften analysiert werden.
Während die messtechnische Erfassung der Teilchengröße bis hin zu wenigen Nanometer prinzipiell gelöst ist (vgl. ISO-Normen des TC 24) und auch zunehmend die Grundlagen der Formbeschreibung und Formmessung der Teilchen erarbeitet sind (vgl. ISO 9276-6 F-DIS).

Insbesondere sind auch Messverfahren bekannt, welche die Sedimentationsgeschwindigkeit oder Flotationsgeschwindigkeit von nano- und mikroskaligen Teilchen bestimmen (vgl. DE 41 16 313, EP 0760092, EP 0840887). All diese Verfahren sind nicht in der Lage magnetische Eigenschaften der Teilchen zu charakterisieren.

Die Veröffentlichung US2003/113926 offenbart ein Verfahren und eine Vorrichtung zur Charakterisierung und Bestimmung von Partikeleigenschaften durch die Wirkung überlagerter Felder (ein Gravitationsfeld und ein elektrisches Feld). Die Position der Partikel wird im Gleichgewicht ermittelt.

Die Veröffentlichung US-A-5095451 offenbart das Detektieren zeitlich und örtlich aufgelöster Konzentrationsprofile von Partikeln in einer von einem Zentrifugalkraft ausgesetzten Suspension zur Bestimmung der Partikelgrößenverteilung (Spalte 2, Zeile 37-59).

Aufgabenstellung:

Aus diesen grundsätzlichen technischen Problemen ergibt sich als Aufgabe der Erfindung die Bereitstellung eines Verfahrens und einer Vorrichtung, die es ermöglicht magnetische Eigenschaften, wie die Magnetisierbarkeit oder die Suszeptilität, von nano- und mikroskaligen Teilchen von Dispersionen zu vermessen und deren Verteilung anzugeben.

Die Aufgabe wird durch ein Verfahren und eine Vorrichtung, die in den unabhängigen Ansprüchen 1 und 23 dargestellt sind, gelöst. Vorteilhafte Ausgestaltungen des Verfahrens und der Vorrichtung, die jedoch nicht erschöpfend sind, sind Gegenstand abhängiger Unteransprüche.

Die Erfindung basiert auf dem Grundgedanken, die durch Gravitationsfelder bzw. Zentrifugalfelder induzierte Entmischung von Teilchen einer Dispersion durch ein zusätzliches oder mehrere zusätzliche, die Migration der Teilchen ebenfalls beeinflussende Kraftfelder, zu modellieren. Diese zusätzlichen Kräfte werden die Bewegung der Teilchen beschleunigen oder verlangsamen. Durch die Richtung der zusätzlichen Kraftfelder und deren Betrag lassen sich die zusätzlichen Kräfte ändern. So kann im Fall von monodispersen Teilchen gleicher Form und Zusammensetzung durch die "Aufschaltung" einer der Zentrifugalkraft gleichen, aber entgegengesetzten magnetischen Feldkraft die Sedimentation vollständig gestoppt werden. Es ist aber auch möglich, bei der Vorgabe eines konstanten magnetischen Feldes die Zentrifugalkraft durch die Änderung der Drehzahl bis zum Kraftgleichgewicht zu ändern. Diese zweite Realisierung ist aus technischer Sicht besonders einfach zu realisieren.

Man kann nun mit konzentrationsmessenden Sensoren das geänderte Entmischungsverhalten detektieren und insbesondere die zu jedem Zeitpunkt und jedem Ort vorhandene Teilchenkonzentration z.B. photometrisch vermessen. Aus der Änderung der Konzentration lassen sich in Abhängigkeit von den wirkenden Feldvektoren über den Massenstrom die diese hervorrufen Teilchengeschwindigkeiten berechnen. Aus der Änderung der Geschwindigkeit kann die auf die Teilchen einwirkende Kraft berechnet werden und bei Kenntnis der entsprechenden Feldstärken lassen sich daraus die entsprechenden Teilcheneigenschaften berechnen.

Als zusätzliche Felder können homogene oder inhomogene magnetische oder elektrische Felder den Gravitationsfeldern bzw. Zentrifugationsfeldern in beliebiger Ausrichtung, vorzugsweise parallel oder orthoparallel überlagert werden. Es ist vorteilhaft mehrere statische Feldstärken einsetzen zu können und/oder dynamische Änderungen während einer Messung mittels einer Steuerungssoftware zu realisieren. Das Grundverfahren besteht darin, dass als erster Schritt die Geschwindigkeitsverteilung infolge des Gravitationsfeldes oder eines wählbaren Zentrifugalfeldes ohne zusätzliches Feld gemessen wird und nach Zuschaltung eines magnetischen oder elektrischen Feldes, welches der Migration der Partikel z. B. entgegen wirkt, die Geschwindigkeitsverteilung erneut gemessen wird.

Bereits aus der Verringerung der mittleren Geschwindigkeit der Partikel ist es möglich unterschiedliche Teilchen qualitativ zu klassifizieren. Es ist weiterhin möglich, dass die diese Änderung bewirkende mittlere magnetische Kraft mittels eines Softwaremoduls berechnet wird. Detailliertere Analysen vergleichen die gemessene Geschwindigkeitsverteilungen vor und nach Applikation des Magnetfeldes, indem eine vorgegebene Verteilungsfunktion (z.B. Normal distribution, log normal distribution, power distribution, etc) oder eine freie Fitfunktion angepasst werden und aus den Geschwindigkeitsunterschieden der einzelnen Partikelklassen, die diese Änderung bewirkende magnetische Kraft pro Partikelklasse berechnet und als Verteilung dargestellt wird.

Aus den ermittelten magnetischen Kräften kann bei Kenntnis der magnetischen Feldes entsprechend der folgenden Gleichung:

$$F_{mag} = \mu_o \cdot V_p \cdot M_p \cdot \nabla H$$

die mittlere Partikelmagnetisierung $M_p$ bzw. deren Verteilung über die Partikelklassen bestimmt wird und mit $M_p = \chi H$ die mittlere Suszeptilität bzw. deren Verteilung errechnet werden. Ist andererseits die magnetische Flussdichte bekannt, kann entsprechend die mittlere Suszeptilität bzw. deren Verteilung bestimmt wird.

Neben magnetischen Feldern sind auch homogene oder inhomogen elektrische Felder einsetzbar. Vergleichbar weiter oben, wird als erster Schritt die Geschwindigkeitsverteilung ohne elektrisches Feld gemessen und nach Zuschaltung eines elektrischen Feldes, welches z.B. der Migration der Partikel entgegen wirkt, die Geschwindigkeitsverteilung erneut gemessen. Aus der Verringerung der mittleren Geschwindigkeit der Partikel wird die, diese Verringerung bewirkende mittlere elektrische Kraft für permanent geladene Partikel oder dielektrische Kraft für Partikel mit Dipoleigenschaften mittels eines Softwaremoduls berechnet wird. Detaillierter Auswertungen erfolgen in Analogie zum magnetischen Feld und ergeben für geladenen Teilchen die elektrophoretische Beweglichkeit und/oder für Dipolteilchen in einem inhomogenen elektrischen Feld die dielektrische Beweglichkeit.

Werden z. B. Permanentmagneten seitlich zu der die Dispersion magnetischer oder magnetisierbarer Teilchen aufnehmenden Küvetten angeordnet, sammeln sich bei der Nord-Süd-Ausrichtung der Magnete im Ruhezustand die Teilchen zwischen den Magnetpolen (Ausbildung einer Brücke). Wird die Küvette mit den seitlich befestigten Magneten radial auf einen Rotor fixiert und die Drehzahl der Zentrifuge stetig erhöht, wird die "Brücke" in radialer Richtung verformt. Das Ausmaß der Verformung bzw. die Drehzahl, wenn die "Brücke" reißt, ermöglicht die Klassifizierung der magnetischen Eigenschaften der Teilchen.

Überraschend hat sich gezeigt, dass sich auch infolge von Temperaturgradienten über der Probe senkrecht zur Migrationsrichtung der Teilchen unter gleichzeitiger Einwirkung einer Gravitations- oder Zentrifugalkraft Veränderungen des Entmischungsverhaltens ergeben und diese z. B. mit der Dispergierbarkeit der Teilchen in Zusammenhang stehen.

Die Vorrichtung zur Charakterisierung und Bestimmung der magnetischen und elektrischen Partikeleigenschaften ermöglicht es ein oder mehrere geeignete Probenaufnahmegefäße in Richtung des Gravitationsfeldes oder eines Zentrifugalfeldes zu platzieren und durch weitere Vorrichtungen zusätzliche, wahlweise zuschaltbare physikalische Felder, deren Richtung und Stärke frei wählbar ist, und welche das Probenaufnahmegefäß durchdringen zu applizieren. Die Konzentrationssensoren so angebracht sind, dass sie ohne die feldinduzierte Migration der Teilchen zu beinträchtigen, die Teilchenkonzentration räumlich und zeitlich aufgelöst messen und diese Daten von einem Mikro-Controller, welcher auch die gesamte Steuerung des Gerätes und der Sensoren realisiert, verarbeitet, an einem PC gesandt und dort gespeichert und online bzw. offline ausgewertet werden.

Zur Überlagerung des Gravitationsfeldes mit einem magnetischen Feld sind ein oder mehrere Aufnahmevorrichtungen für ein oder mehrere Permanentmagnete bezüglich der Probenaufnahmegefäße so integriert und ausgestaltet sind, dass die Richtung des Magnetfeldes in unterschiedlichen Winkeln bezogen auf das Gravitationsfeld appliziert werden kann. Vorteilhaft ist es auch zur Erzeugung des magnetischen Feldes eine entsprechende stromdurchflossene Spule oder Spulen einzusetzen und die Feldstärke dieser Spulen durch eine Steuerungssoftware dynamisch zu ändern.

Vorrichtung nach Anspruch 12, **dadurch gekennzeichnet, dass** die Spule bzw. Spulen das Probengefäß im Spuleninneren aufnehmen oder das Probengefäß oder die Probengefäße im durch mehrere Spulen erzeugten magnetischen Feld platziert werden.

Zur Überlagerung des Zentrifugalfeldes mit einem magnetischen Feld wird auf dem Rotor eine oder mehrere mitdrehende oder über bzw. unter dem Rotor eine oder mehrere stationäre Aufnahmevorrichtungen für einen oder mehrere Permanentmagnete so integriert und ausgestaltet, dass die Richtung des Magnetfeldes bezüglich der Richtung der Zentrifugalkraft zwischen 0° und 180 ° variiert werden kann. Zur Erzeugung des magnetischen Feldes können auch eine entsprechende stromdurchflossene Spule oder Spulen eingesetzt werden können und die Feldstärke dieser Spulen durch eine Steuerungssoftware dynamisch geändert werden. Im Falle einer Spule bzw. Spulen kann das Probengefäß im Spuleninneren oder dass das Probengefäß oder die Probengefäße im durch mehrere Spulen erzeugten magnetischen Feld platziert werden. Es ist vorteilhaft, dass ein oder mehrere Sensoren die magnetische Feldstärke erfassen.

Für die Bestimmung elektrischer Parameter sind in die Probengefäße Elektroden zur Applikation eines stationären oder dynamischen elektrischen Feldes integriert, welche durch die Anordnung und Form der Elektroden homogene oder inhomogene Felder erzeugen können.

Der Einsatz einer variablen Wärmestrahlungsquelle, welche senkrecht zur durch das Gravitationsfeld oder das Zentrifugalfeld induzierten Migrationsrichtung der Teilchen ausgerichtet ist, kann einfach ein Temperaturgradient innerhalb der Probe realisiert werden.

Die Vorrichtung zeichnet sich weiterhin dadurch aus, dass auf elektromagnetischen oder akustischen Wellen beruhende Konzentrationssensoren in das Probengefäß integriert sind oder das Probengefäß durchstrahlen. Eine Ausprägung der Sensoren besteht in Form einer oder mehrerer in der Hauptmigrationsrichtung der Teilchen ausgerichteten CCD-Zeile oder eines CCD-Arrays. Die monochromatische oder polychromatische Durchstrahlung der Messprobe über die gesamte Probenlänge erfolgt mit einer parallele Strahlung emittierenden Quelle oder mit parallelisierter Strahlung.

**Patentansprüche**

1. Verfahren zur Charakterisierung und Bestimmung von Partikeleigenschaften durch die Wirkung überlagerter Felder, wobei die durch Gravitationsfelder bzw. Zentrifugalfelder induzierte Entmischung von Teilchen einer Dispersion durch ein zusätzliches oder mehrere zusätzliche, die Migration der Teilchen ebenfalls beeinflussende Kraftfelder, moduliert wird **dadurch gekennzeichnet, dass** mit konzentrationsmessenden Sensoren das durch in Abhängigkeit von dem Betrag und der Richtung der zusätzlich wirkenden Kräfte geänderte Entmischungsverhalten mittels zeitlich und örtlich aufgelöster Konzentrationsprofile über die gesamte Probenlänge charakterisiert wird und die Änderung der Teilchenkonzentration als Maß für die Partikeleigenschaften, auf welche die zusätzlichen Kräfte einwirken, bestimmt wird und/oder aus den zeitlich und örtlich aufgelösten Konzentrationsprofilen die in Abhängigkeit von dem Betrag und der Richtung der zusätzlich wirkenden Kräfte erfolgten Änderungen der Geschwindigkeitsvektoren der Teilchen ermittelt und daraus, die Eigenschaft der Partikel auf die die zusätzliche Kraft bzw. die zusätzlichen Kräfte wirken, qualitativ und/oder quantitativ bestimmt werden.

2. Verfahren nach Anspruch 1, **dadurch gekennzeichnet, dass** als zusätzliche Felder homogene oder inhomogene magnetische oder elektrische Felder den Gravitationsfeldern bzw. Zentrifugationsfeldern in beliebiger Ausrichtung, vorzugsweise parallel oder orthoparallel überlagert sind und mehrere statische Feldstärken wählbar und/oder dynamische Änderungen während einer Messung mittels der Steuerungssoftware realisierbar sind.

3. Verfahren nach Anspruch 1 und 2, **dadurch gekennzeichnet, dass** als erster Schritt die Geschwindigkeitsverteilung ohne zusätzliches Feld gemessen wird und

    a) nach Zuschaltung eines magnetischen Feldes, welches der Migration der Partikel entgegen wirkt, die Geschwindigkeitsverteilung erneut gemessen wird und aus der Verringerung der mittleren Geschwindigkeit der Partikel die, diese Verringerung bewirkende mittlere magnetische Kraft mittels eines Softwaremoduls berechnet wird oder

    b) nach Zuschaltung eines elektrischen Feldes, welches der Migration Partikel entgegen wirkt, die Geschwindigkeitsverteilung erneut gemessen wird und aus der Verringerung der mittleren Geschwindigkeit der Partikel die, diese Verringerung bewirkende mittlere elektrische Kraft für permanent geladene Partikel oder dielektrische Kraft für Partikel mit Dipoleigenschaften mittels eines Softwaremoduls berechnet wird.

4. Verfahren nach Anspruch 3, **dadurch gekennzeichnet, dass** die gemessene Geschwindigkeitsverteilungen

    a) vor und nach Applikation des Magnetfeldes durch eine vorgegebene Verteilungsfunktion (z.B. Normal distribution, log normal distribution, power distribution, etc) oder eine freie Fitfunktion angepasst werden und aus den Geschwindigkeitsunterschieden der einzelnen Partikelklassen, die diese Änderung bewirkende magnetische Kraft pro Partikelklasse berechnet wird und als Verteilung dargestellt wird oder
    b) vor und nach Applikation des elektrischen Feldes durch eine vorgegebene Verteilungsfunktion (z.B. Normal distribution, log normal distribution, power distribution, etc) oder eine freie Fitfunktion angepasst werden und aus den Geschwindigkeitsunterschieden der einzelnen Partikelklassen, die diese Änderung bewirkende elektrische Kraft bzw. dielektrische Kraft pro Partikelklasse berechnet wird und als Verteilung dargestellt wird..

5. Verfahren nach Anspruch 3 und 4, **dadurch gekennzeichnet, dass**

    a) aus den ermittelten magnetischen Kräften bei Kenntnis der magnetischen Feldes entsprechend der folgenden Gleichung:

$$F_{mag} = \mu_0 \cdot V_p \cdot M_p \cdot \nabla H$$

die mittlere Partikelmagnetisierung $M_p$ bzw. deren Verteilung über die Partikelklassen bestimmt wird und mit $M_p = \chi H$ die mittlere Suszeptilität $\chi$ bzw. deren Verteilung errechnet wird
oder bei Kenntnis der magnetischen Flussdichte entsprechend folgender Gleichung

$$F_{mag} = \frac{1}{\mu_0} \cdot \chi \cdot V_P \cdot B \cdot \nabla B$$

die mittlere Suszeptilität bzw. deren Verteilung bestimmt wird oder

b) aus den ermittelten elektrischen Kräften bei Kenntnis des elektrischen Feldes für geladene Teilchen entsprechend der folgenden Gleichung

$$b_e = \frac{V}{E} = \frac{Q}{6\Pi \cdot \eta \cdot r}$$

die elektrophoretische Beweglichkeit berechnet wird und/oder für Dipolteilchen in einem inhomogenen elektrischen Feld entsprechend der folgenden Gleichung

$$b_d = \frac{V}{\Delta/E/^2} = \frac{V_\rho \cdot \varepsilon_o \cdot K_e}{4\Pi \cdot \eta \cdot r}$$

die dielektrische Beweglichkeit berechnet wird.

6. Verfahren nach Anspruch 1 und 2 **dadurch gekennzeichnet, dass** das Magnetfeld senkrecht zur Migrationsrichtung der Teilchen in einer Zentrifuge ausgerichtet wird, den magnetischen bzw. magnetisierbaren Teilchen die Anordnung entlang der Feldlinien im Ruhezustand der Zentrifuge ermöglicht wird und danach schrittweise ein Zentrifugalfeld appliziert, die Dislokation der Teikhenanordnung durch das Zentrifugenfeld gemessen und aus der Positionsänderung in Relation zur Zentrifugalkraft ein die magnetischen Eigenschaften charakterisierender Verformungsindex gebildet wird.

7. Verfahren nach Anspruch 1 und 2, **dadurch gekennzeichnet, dass** zusätzlich zur Bestimmung der Entmischungsgeschwindigkeit mit und ohne überlagerten Feldern dieses auch bei unterschiedlichen wählbaren Temperaturen der Probe realisiert werden kann und auch Temperaturgradienten über die Probe senkrecht zur Migrationsrichtung der Teilchen infolge der einwirkenden Gravitations- oder Zentrifugalkraft angelegt werden können.

8. Vorrichtung zur Charakterisierung und Bestimmung von Partikeleigenschaften, wobei ein oder mehrere geeignete Probenaufnahmegefäße in Richtung des Gravitationsfeldes oder eines Zentrifugalfeldes platzierbar ist oder sind und durch weitere Vorrichtungen zusätzliche, wahlweise zuschaltbare physikalische Felder, deren Richtung und Stärke frei wählbar ist, das Probenaufnahmegefäß durchdringen, **dadurch gekennzeichnet, dass** Konzentrationssensoren so angebracht sind, dass sie ohne die feldinduzierte Migration der Teilchen zu beinträchtigen, die Teilchenkonzentration räumlich und zeitlich aufgelöst messen und diese Daten von einem Mikro-Controller, welcher auch die gesamte Steuerung des Gerätes und der Sensoren realisiert, verarbeitet, an einen PC gesandt und dort gespeichert und online bzw. offline ausgewertet werden.

9. Vorrichtung nach Anspruch 8, **dadurch gekennzeichnet, dass** zur Überlagerung des Gravitationsfeldes mit einem magnetischen Feld

a) ein oder mehrere Aufnahmevorrichtungen für ein oder mehrere Permanentmagnete bezüglich der Probenaufnahmegefäße so integriert und ausgestaltet sind, dass die Richtung des Magnetfeldes in unterschiedlichen Winkeln bezogen auf das Gravitationsfeld appliziert werden kann oder

b) auf einem Rotor eine oder mehrere mitdrehende oder über bzw. unter dem Rotor eine oder mehrere stationäre Aufnahmevorrichtungen für einen oder mehrere Permanentmagnete so integriert und ausgestaltet sind, dass die Richtung des Magnetfeldes bezüglich der Richtung der Zentrifugalkraft zwischen 0° und 180° variiert werden kann..

10. Vorrichtung nach Anspruch 9, **dadurch gekennzeichnet, dass**

a) zur Erzeugung des magnetischen Feldes auch eine entsprechende stromdurchflossene Spule oder Spulen eingesetzt werden können und die Feldstärke dieser Spulen durch eine Steuerungssoftware dynamisch geändert werden kann oder

b) zur Applikation eines stationären oder dynamischen elektrischen Feldes in die Probengefäße Elektroden integriert sind.

11. Vorrichtung nach Anspruch 10, **dadurch gekennzeichnet, dass** die Spule bzw. Spulen das Probengefäß im Spuleninneren aufnehmen oder das Probengefäß oder die Probengefäße im durch mehrere Spulen erzeugten magnetischen Feld platziert werden, wobei vorzugsweise die Feldstärke dieser Spulen durch eine Steuerungssoftware dynamisch geändert werden kann und / oder ein oder mehrere Sensoren die magnetische Feldstärke erfassen.

12. Vorrichtung nach Anspruch 10 und 11, **dadurch gekennzeichnet, dass** durch die Anordnung und Form der Elektroden homogene oder inhomogene Felder erzeugt werden können.

13. Vorrichtung nach Anspruch 8, **dadurch gekennzeichnet, dass** durch eine variable Wärmestrahlungsquelle, welche senkrecht zur durch das Gravitationsfeld oder das Zentrifugalfeld induzierten Migrationsrichtung der Teilchen ausgerichtet ist, ein Temperaturgradient innerhalb der Probe realisiert werden kann.

**14.** Vorrichtung nach Anspruch 8 bis 13, **dadurch gekennzeichnet, dass** auf elektromagnetische oder akustische Wellen beruhende Konzentrationssensoren in das Probengefäß integriert oder das Probengefäß durchstrahlen.

**15.** Vorrichtung nach Anspruch 14, **dadurch gekennzeichnet, dass** eine Ausprägung der Sensoren in Form einer oder mehrerer in der Hauptmigrationsrichtung der Teilchen ausgerichteten CCD-Zeile oder eines CCD-Arrays realisiert wird und die monochromatische oder polychromatische Durchstrahlung der Messprobe über die gesamte Probenlänge mit einer parallele Strahlung emittierenden Quelle oder mit parallelisierter Strahlung erfolgt.

**Claims**

**1.** A method for characterization and determination of particle properties by the impact of superimposed fields, with the gravitational field-induced and/or centrifugal field-induced separation of particles of a dispersion being modeled by means of one or more additional force fields that also influence the migration of the particles, **characterized in that** by means of concentration-measuring sensors the separation behaviour - modified as a function of amount and direction of the forces operating in addition - is **characterized** across the entire sample length by means of concentration profiles resolved in time and space, and the modification of the particles concentration is determined as a quantity for the particle properties upon which the additional forces act, and/or the modifications of the velocity vectors of the particles are determined from the concentration profiles resolved in time and space which have occurred as a function of the amount and direction of the forces acting in addition, and from that the property of the particles upon which the additional force and/or the additional forces act, is determined qualitatively and/or quantitatively.

**2.** A method according to claim 1, **characterized in that** as additional fields homogeneous or inhomogeneous magnetic or electric fields are superimposed to the gravitational and/or centrifugational fields in any orientation, preferably parallel or orthoparallel and several static field intensities are selectable and/or dynamic modifications can be realized during a measurement by means of the control software.

**3.** A method according to claim 1 and 2, **characterized in that** in a first step the velocity distribution is measured without an additional field and

   a) after connection of a magnetic field counteracting particle migration, the velocity distribution is measured again, and from the reduction of the mean velocity of the particles the mean magnetic force causing such reduction is calculated by means of a software module,
   or
   b) after connection of an electric field counteracting particle migration, the velocity distribution is measured again, and from the reduction of the mean velocity of the particles the mean electrical force causing such reduction for permanently charged particles or the dielectric force for particles with dipole properties is calculated by means of a software module

**4.** A method according to claim 3, **characterized in that** the measured velocity distributions a) before and after application of the magnetic field are adjusted by a given distribution function (for example normal distribution, log normal distribution, power distribution etc.) or a free fit function, and that from the velocity differences of the individual particle classes the magnetic force per particle class causing such modification is calculated and is represented as a distribution
   or

   b) before and after application of the electric field are adjusted by a given distribution function (for example normal distribution, log normal distribution, power distribution etc.) or a free fit function and from the velocity differences of the individual particle classes the electric force and/or dielectric force per particle class causing such modification is calculated and represented as a distribution.

**5.** A method according to claim 3 and 4, **characterized in that**

   a) from the magnetic forces determined, if the magnetic field is known, according to the following equation:

$$F_{mag} = \mu_o \cdot V_p \cdot M_p \cdot \nabla H$$

   the mean particle magnetization M and/or its distribution across the particle classes is determined and with $M_p = \chi H$ the mean susceptibility $\chi$ and/or its distribution is calculated
   or, if the magnetic flux density is known, according to the following equation

$$F_{mag} = \frac{1}{\mu_o} \cdot \chi \cdot V_P \cdot B \cdot \nabla B$$

the mean susceptibility and/or its distribution is determined or
b) from the electrical forces determined, if the electric field is known, for charged particles according to the following equation

$$b_e = \frac{V}{E} = \frac{Q}{6\Pi \cdot \eta \cdot r}$$

the electrophoretic mobility is calculated and/or for dipole particles in an inhomogeneous electric field according to the following equation

$$b_d = \frac{V}{\Delta / E / ^2} = \frac{V_p \cdot \varepsilon_o \cdot K_e}{4\Pi \cdot \eta \cdot r}$$

the dielectric mobility is calculated.

6. A method according to claim 1 and 2, **characterized in that** the magnetic field is oriented vertically to the migration direction of the particles within a centrifuge, in state of rest of the centrifuge, arrangement alongside the flux lines is permitted to the magnetic and/or magnetizable particles, and subsequently step by step a centrifugal field is applied, dislocation of the particle arrangement through the centrifugal field is measured and from change of position relative to the centrifugal force a deformation index is established characterizing the magnetic properties.

7. A method according to claim 1, **characterized in that** in addition to determination of the velocity of separation with and without superimposed fields, this can also be realized for different selectable temperatures of the sample and also temperature gradients can be applied across the sample vertically to the migration direction of the particles due to the impacting gravitational or centrifugal force.

8. A device for characterization and determination of particle properties, with one or several appropriate sample vessels being able to be placed in the direction of the gravitational field or a centrifugal field, and by further devices additional physical fields, which can be added optionally, and the direction and intensity of which is freely selectable, penetrating the sample vessel, **characterized in that** concentration sensors are attached in such a way that - without impairing the field-induced migration of the particles - they measure the particle concentration resolved in space and time, and these data are processed by a microcontroller realizing also the entire control of the unit and the sensors, sent to a PC (personal computer), saved there and evaluated online and/or offline.

9. A device according to claim 8, **characterized in that** for superimposition of the gravitational field with a magnetic field

a) one or several mounting devices for one or several permanent magnets are integrated and formed with respect to the samples vessels such that the direction of the magnetic field can be applied in different angles relative to the gravitational field
or
b) on a rotor one or several mounting devices rotating simultaneously or one or several stationary mounting devices above and/or below the rotor for one or several permanent magnets are integrated and formed such that the direction of the magnetic field relative to the direction of the centrifugal force can be varied between 0° and 180°.

10. A device according to claim 9, **characterized in that**

a) for generation of the magnetic field also a corresponding current-carrying coil or coils can be used and the field intensity of these coils can be changed dynamically by means of a control software or
b) for application of a stationary or dynamic electric field electrodes are integrated into the sample vessels.

11. A device according to claim 10, **characterized in that** the coil and/or coils accommodate the sample vessel inside the coil or the sample vessel(s) are placed in the magnetic field generated by several coils with the field intensity of these coils preferably being able to be dynamically changed by a control software and/or one or several sensors detecting the magnetic field intensity.

12. A device according to claim 10 and 11, **characterized in that** due to the arrangement and form of the electrodes homogeneous or inhomogeneous fields can be generated.

13. A device according to claim 8, **characterized in that** by a variable heat radiation source, which is oriented vertically to the gravitational field-induced or the centrifugal field-induced migration direction of the particles, a temperature gradient can be realized within the sample.

14. A device according to claim 8 to 13, **characterized in that** concentration sensors based upon electromagnetic or acoustic waves are integrated into the sample vessel or radiate through the sample vessel.

15. A device according to claim 14, **characterized in that** a specification of the sensors in the form of one CCD line or several CCD lines or a CCD array oriented towards the main migration direction of the particles is realized and the monochromatic or polychromatic radiation of the test sample across the entire sample length is made by means of a source emitting parallel radiation or by means of parallelized radiation.

## Revendications

1. Procédé pour la caractérisation et la détermination des propriétés des particules par l'effet des champs superposés, la ségrégation, induite par des champs de gravitation et/ou centrifuges, des particules d'une dispersion étant modulé par un champ de force additionnel ou plusieurs champs de force additionnels influant également sur la migration des particules, **caractérisé en ce qu'**avec des capteurs mesurant la concentration le comportement de ségrégation, modifié en fonction du montant et de la direction des forces opérant en plus, est **caractérisé** à travers toute la longueur de l'échantillon au moyen des profils de concentration dissous temporellement et localement, et la modification de la concentration des particules est déterminée en tant que grandeur pour les propriétés des particules sur lesquelles les forces additionnelles agissent, et/ou à partir des profils de concentration dissous temporellement et localement, les modifications, résultant en fonction du montant et de la direction des forces opérant en plus, des vecteurs de vélocité des particules sont déterminées et à partir de cela la propriété des particules, sur lesquelles la force additionnelle et/ou les forces additionnelles agissent, sont définis d'une manière qualitative et/ou quantitative.

2. Procédé selon la revendication 1, **caractérisé en ce qu'**en tant que champ additionnel des champs homogènes ou inhomogènes magnétiques ou électriques sont superposés aux champs de gravitation et/ou centrifuge dans une orientation quelconque, préférablement parallèle ou ortho-parallèle, et des intensités de champ statiques sont sélectionnables et/ou des modifications dynamiques sont réalisables pendant un mesure au moyen du logiciel de commande.

3. Procédé selon la revendication 1 et 2, **caractérisé en ce qu'**en tant que première étape la distribution de la vélocité sans champ additionnel est mesurée et

    a) après raccordement d'un champ magnétique contrecarrant la migration des particules la distribution de la vélocité est mesurée de nouveau et à partir de la réduction de la vélocité moyenne des particules la force magnétique moyenne provoquant cette réduction est calculée au moyen d'un module de logiciel
ou
    b) après raccordement d'un champ électrique contrecarrant la migration des particules la distribution de la vélocité est mesurée de nouveau et à partir de la réduction de la vélocité moyenne des particules la force électrique moyenne - provoquant cette réduction - pour des particules chargées d'une manière permanente ou la force diélectrique pour des particules avec des propriétés dipolaires est calculée au moyen d'un module de logiciel.

4. Procédé selon la revendication 3, **caractérisé en ce que** les distributions de vélocité mesurées

    a) avant et après application du champ magnétique sont ajustées par une fonction de distribution donnée (par exemple distribution normale, distribution log-normale, distribution de la puissance etc.) ou par une fonction d'ajustement libre et à partir des différences de vélocité des classes de particules individuelles, cette force magnétique par classe de particule provoquant cette modification est calculée et représentée en tant que distribution
ou
    b) avant et après application du champ électrique sont ajustées par une fonction de distribution donnée (par exemple distribution normale, distribution log-normale, distribution de la puissance etc.) ou par une fonction d'ajustement libre et à partir des différences de vélocité des classes de particules individuelles, cette force électrique et/ou force diélectrique par classe de particule provoquant cette modification est calculée et représentée en tant que distribution.

5. Procédé selon la revendication 3 et 4, **caractérisé en ce que**

    a) à partir des forces magnétiques déterminées en connaissant le champ magnétique selon l'équation suivante:

$$F_{mag} = \mu_o \cdot V_p \cdot M_p \cdot \nabla H$$

la magnétisation moyenne M et/ou sa distribution à travers les classes de particules est déterminée et avec $M_p = \chi\ H$ la susceptibilité moyenne $\chi$. et/ou sa distribution est calculée ou en connaissant la densité de flux magnétique selon l'équation suivante

$$F_{mag} = \frac{1}{\mu_o} \cdot \chi \cdot V_P \cdot B \cdot \nabla B$$

la susceptibilité moyenne et/ou sa distribution est déterminée ou

b) à partir des forces électriques déterminées en connaissant le champ électrique pour des particules chargées selon l'équation suivante

$$b_e = \frac{V}{E} = \frac{Q}{6\Pi \cdot \eta \cdot r}$$

la mobilité électrophorétique est calculée et/ou pour des particules dipolaires dans un champ inhomogène électrique selon l'équation suivante:

$$b_d = \frac{V}{\Delta/E\,l^2} = \frac{V_p \cdot \varepsilon_o \cdot K_e}{4\Pi \cdot \eta \cdot r}$$

la mobilité diélectrique est calculée.

6. Procédé selon la revendication 1 et 2, **caractérisé en ce que** le champ magnétique est aligné verticalement à la direction de la migration des particules dans une centrifugeuse, l'agencement selon les lignes de force est permis aux particules magnétiques et/ou magnétisables en état de repos de la centrifugeuse, et ensuite un champ centrifuge est appliqué graduellement, la dislocation de l'agencement des particules à travers le champ centrifuge est mesurée et à partir de la modification de la position en relation avec la force centrifuge un index de déformation est formé caractérisant les propriétés magnétiques.

7. Procédé selon la revendication 1 et 2, **caractérisé en ce qu'**en outre la détermination de la vélocité de ségrégation avec et sans champs superposés cela peut être réalisé aussi dans le cas des températures différentes sélectionnables de l'échantillon et aussi des gradients de température peuvent être appliqués à travers l'échantillon verticalement à la direction de migration des particules par suite de la force de gravitation ou centrifuge agissant sur cela.

8. Dispositif pour la caractérisation et la détermination des propriétés des particules, un récipient d'échantillon ou plusieurs récipients d'échantillon appropriés pouvant être placé dans la direction du champ de gravitation ou d'un champ centrifuge et par des dispositifs ultérieurs des champs physiques additionnel connectables au choix dont la direction et l'intensité est librement sélectionnable pénétrant le récipient d'échantillon, **caractérisé en ce que** des capteurs de concentration sont agencés de manière que, sans gênant la migration des particules induit par le champ, ils mesurent la concentration des particules dissous localement et temporellement et ces données sont traités par un microcontrôleur, réalisant aussi toute la commande de l'appareil et des capteurs, envoyés à un ordinateur, y mémorisés et évalués en ligne et/ou hors ligne.

9. Dispositif selon la revendication 8, **caractérisé en ce que** pour la superposition des champs de gravitation avec un champ magnétique

a) un ou plusieurs moyens de réception pour un ou plusieurs aimants permanents relatif aux récipients d'échantillon sont intégrés et aménagés de manière que la direction du champ magnétique peut être appliqué dans des angles différentes relatif au champ de gravitation ou

b) sur un rotor un ou plusieurs moyens de réception tournant simultanément ou au dessus et/ou au-dessous le rotor un ou plusieurs moyens de réception fixes pour un ou plusieurs aimants permanents sont intégrés et aménagés de manière que la direction du champ magnétique peut être varié entre 0° et 180° relatif à la direction de la force centrifuge.

10. Dispositif selon la revendication 9, **caractérisé en ce que**

a) pour générer le champ magnétique aussi une bobine ou des bobines correspondantes parcourues par le courant peuvent être utilisées et l'intensité du champ de ces bobines peuvent être modifiée dynamiquement par un logiciel de commande ou

b) pour l'application d'un champ électrique stationnaire ou dynamique des électrodes sont intégrées dans les récipients d'échantillon.

11. Dispositif selon la revendication 10, **caractérisé en ce que** la bobine et/ou les bobines portent le récipient d'échantillon dans son intérieur ou le récipient d'échantillon ou les récipients d'échantillon sont placés dans le champ magnétique généré par plusieurs bobines, l'intensité du champ de ces bobines pouvant être modifié préférablement d'une manière dynamique et/ou un ou plusieurs capteurs captant l'intensité du champ.

**12.** Dispositif selon la revendication 10 et 11, **caractérisé en ce que** par l'agencement et la forme des électrodes des champs homogènes ou inhomogènes peuvent être générés.

**13.** Dispositif selon la revendication 8, **caractérisé en ce que** par une source de radiation thermique variable orientée verticalement à la direction de migration des particules induite par le champ de gravitation ou le champ centrifuge un gradient de température dans l'échantillon peut être réalisé.

**14.** Dispositif selon la revendication 8 à 13, **caractérisé en ce que** des capteurs de concentration basés sur des ondes électromagnétiques ou acoustiques sont intégrés dans le récipient d'échantillon ou rayonnent à travers le récipient d'échantillon.

**15.** Dispositif selon la revendication 14, **caractérisé en ce qu'**une spécification des capteurs est réalisée sous forme d'une ou plusieurs lignes CCD ou d'un tableau CCD orientés dans la direction principale de migration et le rayonnement monochromatique ou polychromatique de l'échantillon de mesurage est effectué à travers la longueur totale de l'échantillon avec une source émettant une radiation parallèle ou avec de la radiation parallélisée.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4116313
- EP 0760092 A
- EP 0840887 A
- US 2003113926 A
- US 5095451 A